Europäisches Patentamt

European Patent Office

Office européen des brevets

(11) Publication number: **0 319 021 B1**

# EUROPEAN PATENT SPECIFICATION

(45) Date of publication of patent specification: **18.11.93**   (51) Int. Cl.⁵: **H01L  21/31**, **C23C 16/22**, **C23C 16/48**

(21) Application number: **88120152.9**

(22) Date of filing: **02.12.88**

(54) **Apparatus for laser chemical vapour deposition.**

(30) Priority: **04.12.87 JP 307906/87**

(43) Date of publication of application:
**07.06.89 Bulletin  89/23**

(45) Publication of the grant of the patent:
**18.11.93 Bulletin  93/46**

(84) Designated Contracting States:
**FR GB**

(56) References cited:
**EP-A- 0 229 633**

**EXTENDED ABSTRACTS, vol. 86-1, no. 1, May 1986, pages 208-209, abstract no. 149, Pennington, New Jersey, US; E.W. SABIN: "Laser activated CVD of silicon dioxide and silicon nitride"**

**EXTENDED ABSTRACTS/ELECTROCHEMICAL SOCIETY, vol. 87-2, 1987, page 1071, abstract no. 746, Princeton, New Jersey, US; T. TANAKA et al.: "Stoichiometry control in laser CVD SiO2"**

**SOLID STATE TECHNOLOGY, vol. 28, no. 6, June 1985, pages 220-227, Port Washington,**

**New York, US; R. SOLANKI et al.: "Laser-induced chemical vapor deposition"**

(73) Proprietor: **FUJITSU LIMITED**
**1015, Kamikodanaka**
**Nakahara-ku**
**Kawasaki-shi Kanagawa 211(JP)**

(72) Inventor: **Mukai, Ryoichi**
**Fujitsu Ltd.**
**Patent Department**
**1015 Kamikodanaka**
**Nakahara-ku Kawasaki-shi Kanagawa 211(JP)**

(74) Representative: **Greenstreet, Cyril Henry et al**
**Haseltine Lake & Co.**
**Hazlitt House**
**28 Southampton Buildings**
**Chancery Lane**
**London WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates generally to the manufacture of a semiconductor device, and, more specifically, to an apparatus for performing a method for forming a deposition film using a laser CVD technique by irradiating a reaction gas with a laser beam, generating a reaction product through decomposition and reaction of reaction gas and forming the reaction product on a substrate.

It is generally known to form a thin film of polysilicon and oxide on a semiconductor substrate by chemical vapour deposition (CVD), in which a reaction gas is introduced into a processing chamber containing a semiconductor substrate, a reaction product is formed by reaction of the reaction gas, and the reaction product is deposited on the semi conductor substrate.

One such CVD method is the laser CVD method, wherein the reaction gas is irradiated with a laser beam, a reaction product is formed by decomposition and reaction of the reaction gas, and the reaction product is deposited on a substrate. This method has an advantage that damage to the semiconductor substrate surface is minimised by realising growth of a deposition product at a temperature lower than that of a thermal CVD method for thermally decomposing the reaction gas. Also, the laser CVD method assures that plasma energy for the energy of laser used will be lower than that in the non-CVD methods. With such advantages, the laser CVD technique has great potential for future use in wider applications for semiconductor devices.

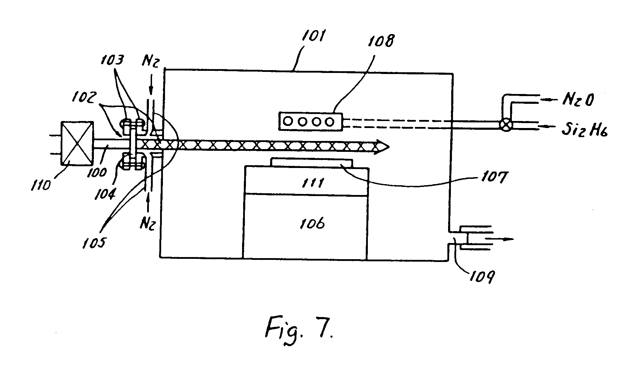

Fig. 7 of the accompanying drawings is a schematic cross-sectional view of a known laser CVD apparatus in which a laser beam 100 passes through a reaction chamber 101 through a laser beam inlet port 102. An O-ring 103 and synthetic quartz window 104 are disposed at the inlet port 102. A gas inlet port 105 is provided for introducing a purge gas, while a support base 106 supports a deposition substrate 107 on a heater 111. A reaction gas is introduced through reaction gas inlet port 108, and exhausted through exhaust port 109. A lens system 110 is also provided.

The laser CVD apparatus of Fig. 7 is used for depositing $SiO_2$. First, the gas in the reaction chamber 101 is exhausted from the exhaust port 109 and the interior of reaction chamber 101 is kept at a constant pressure. Thereafter, the reaction gas, which may include $N_2O$ and $Si_2H_6$, is introduced into the reaction chamber 101 from the reaction gas inlet port 108. Simultaneously, $N_2$ is introduced through the gas inlet port 105 for purging in order to prevent the reaction gas from contacting the laser beam inlet port 102. When the inside of the reaction chamber 101 is exposed to the laser beam 100 which passes through the synthetic quartz window 104 fixed by the O-ring 103, only the reaction gas irradiated by the laser beam is decomposed and reacts, generating a radical beam (indicated by X marks) that appears purple. Thereby, $SiO_2$ is produced and deposited on the deposition substrate 107.

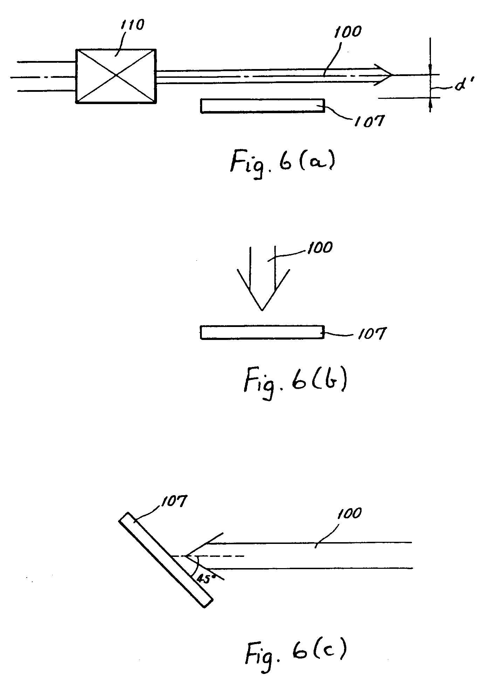

Figs. 6(a)-6(c) are schematic diagrams illustrating a method of forming a deposition film utilising the aforementioned known laser CVD technique. Fig. 7 corresponds to Fig. 6(a).

These Figures illustrate a laser beam 100, a deposition substrate 107, and a lens system 110 for converging the laser beam 100. Fig. 6(a) is a profile for horizontal irradiation where the laser beam 100 is emitted horizontally relative to the deposition substrate 107. Fig. 6(b) is a profile for vertical irradiation where the laser beam 100 is emitted vertically relative to the deposition substrate 107, and Fig. 6(c) is a profile for inclined irradiation where the laser beam 100 is emitted at an inclination angle of 45° relative to the deposition substrate 107.

All three of the above methods have been used to form a deposition film. However, these methods have the following problems:

By the method employing horizontal irradiation, a deposition film can be deposited on a large area but it is difficult to set a clearance d' between the laser beam and deposition substrate 107. If the clearance becomes too large, reaction products combine to create a reaction product powder having a large particle size. When deposited on the substrate, this powder deteriorates film quality. Moreover, since the reaction product is deposited from above, the deposition substrate surface is not irradiated with the laser beam and surface reaction is not easily generated at the surface of the substrate. Also, step coverage is poor in cases where the surface of the deposition substrate 107 includes step and shoulder portions which project from or are recessed into the substrate.

In this method, the energy per unit area must be raised by converging the laser beam with a special lens system 110 called a cylindrical lens in order to raise the deposition rate, and thus the apparatus employed in the method is large and complicated. Moreover, the energy of the laser beam is partly absorbed by the lens system 110 when the laser beam passes therethrough. Therefore, the energy efficiency of the laser beam is deteriorated.

For the method employing vertical irradiation, the irradiation area is narrow because it corresponds to the cross-sectional size of the laser beam. Moreover, the beam size must be enlarged by applying the laser beam 100 to a lens system (not illustrated). However, energy efficiency of the laser beam is deteriorated because the laser beam energy is partly absorbed by the lens system when the laser beam passes through the lens system.

In the method employing irradiation inclined at a 45° angle, a problem similar to that associated with vertical irradiation is experienced.

EP-A-0 229 633 discloses a laser CVD apparatus for forming a deposition film on a deposition substrate, comprising:

a laser source, and

a reaction chamber having a laser inlet port through which a laser beam from the laser source can enter the reaction chamber for irradiating a reaction gas in the reaction chamber with the laser beam, thereby to produce a reaction product by decomposition and reaction of said reaction gas, and deposit said reaction product on a surface of the deposition substrate arranged in the reaction chamber.

In the apparatus of EP-A-0 229 633 the beam passes through the chamber substantially parallel, and contiguous, to the substrate. This, it is stated, is preferably achieved by lenses between the laser source and the laser inlet port.

It is stated that as the beam moves through the chamber, it loses energy.

For compensating for this stated loss of energy as the beam moves through the chamber it is proposed that the substrate be tilted slightly, to decrease the distance between the beam and the substrate as the beam moves through the substrate. It is also proposed that, for the same purpose, the beam may be tapered in the direction along the substrate.

It is suggested that (additional) lenses may be included in the laser inlet port (window) for producing the desired configuration of the beam.

The present invention solves the problems associated with known methods as explained above. It is therefore an object of the present invention to provide apparatus for performing a laser CVD technique which assures a large irradiation area without lowering laser beam energy.

Another object of the invention is to provide a laser CVD apparatus having a capability for easy adjustment of the irradiation angle of the laser beam relative to the deposition substrate.

According to the present invention there is provided a laser CVD apparatus for forming a deposition film on a deposition substrate, comprising:

a laser source, and

a reaction chamber having a laser inlet port through which a laser beam from the laser source can enter the reaction chamber for irradiating a reaction gas in the reaction chamber with the laser beam, thereby to produce a reaction product by decomposition and reaction of said reaction gas, and deposit said reaction product on a surface of the deposition substrate arranged in the reaction chamber,

characterised in that

the apparatus further comprises a beam angle setting mechanism, between the laser source (114) and the laser inlet port, operable to project the laser beam onto the surface of the deposition substrate arranged in the reaction chamber and to set the angle of incidence of the laser beam, in its direction of propagation, for contacting and irradiating the surface of the deposition substrate, at a relatively low angle selected such that the deposition substrate is all included within the beam range of the laser beam in its direction of propagation,

and in that the apparatus lacks any lens system between the laser source and the surface of the deposition substrate arranged in the reaction chamber.

The present invention is capable of expanding the irradiation area without using a lens system by irradiating the deposition substrate surface with the laser beam at a relatively low angle. As explained above, the present invention does not require the use of a lens system to expand the beam diameter of the laser beam. Therefore, the laser beam energy is not lowered by the lens system. Moreover, adjustment of clearance between the laser beam and the deposition substrate is no longer necessary, unlike in horizontal irradiation.

In addition, even if the deposition substrate surface has projecting and/or recessed portions, since the laser beam repeats its reflection in these projecting and recessed portions by irradiating the uneven surfaces with the laser beam at a small angle, the parts behind the projecting and recessed portions and the stepped portion are also irradiated with the laser beam, and thus, step coverage is improved.

Embodiments of the invention will now be described in more detail with reference to the accompanying drawings, in which:

Fig. 1 is a sectional view of an apparatus embodying the present invention;

Figs. 2(a) to 2(c) are schematic diagrams illustrating a method of forming a deposition film implemented in the apparatus according to the present invention;

Fig. 3 is a schematic diagram illustrating the effect on a stepped surface of a low-angled laser beam according to the present invention;

Fig. 4 is a graph illustrating comparative deposition rates obtained with the apparatus according to the present invention and with prior apparatuses;

Fig. 5 is a schematic diagram illustrating a method of setting the irradiation angle of the laser beam which can be employed with the apparatus according to the present invention;

Fig. 6(a) to 6(c) are schematic sectional views illustrating a known laser beam irradiation method; and

Fig. 7 is a schematic sectional view of a known laser CVD apparatus.

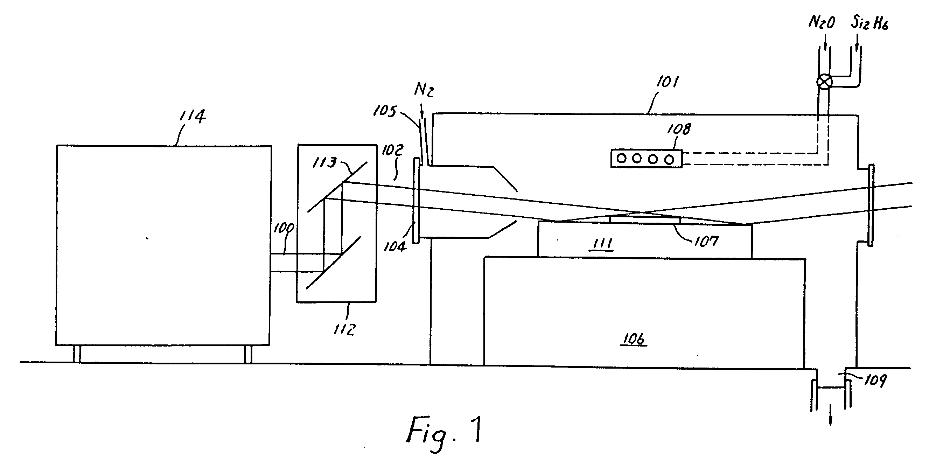

A preferred embodiment of an apparatus embodying the present invention is shown in Fig. 1.

Fig. 1 illustrates a laser beam 100 which enters a reaction chamber 101 through a laser inlet port 102 and a synthetic quartz window 104. A gas inlet port 105 introduces gas for purging. A stage 106 movable horizontally in the X and Y directions supports a heater 111, and a deposition substrate 107 is placed on the heater 111. A reaction gas inlet port 108 introduces reaction gas into the reaction chamber 101. A beam angle setting mechanism 112 includes a mirror body 113 and an ArF excimer laser source 114. Although there are many different types of lasers, the "excimer" laser is preferred. An excimer laser is a laser containing a noble gas, such as argon, which is based on a transition between an excited state in which a metastable bond exists between two gas atoms and a rapidly dissociating ground state. When being separated into two atoms, the excimer laser produces ultraviolet radiation corresponding to the difference between energy levels, and thus, the excimer laser is produced by ultraviolet radiation. As an example, $SiO_2$, which is obtained from the coupling of $N_2O$ and $Si_2H_6$, is stable so that it does not change to another state. In contrast, ArF is obtained from the coupling of Ar and F and is very unstable so that it easily divides into the original atoms, Ar and F. In the process of separating into Ar and F, an ultraviolet radiation excimer laser is produced.

The laser CVD apparatus of Fig. 1 is used for depositing $SiO_2$. First, the gas in the reaction chamber 101 is exhausted from the exhaust port 109 to keep the pressure within the reaction chamber 101, for example, at about 4 Torr. Next, the reaction gas, which includes $N_2O$ and $Si_2H_6$, is introduced into the reaction chamber 101 in the amount of about 200 SCCM and 0.2 SCCM, respectively, from the reaction gas inlet port 108. The reaction gas may also be a mixture of $N_2O$ + $Si_3H_8$, $O_2$ + $Si_3H_6$, or $O_2$ + $Si_3H_8$. For depositing a SiN layer, $NH_3$ + $Si_2H_6$ or $NH_3$ + $Si_3H_8$ may be used. For an Si layer, $Si_8H_6$ and $Si_3H_8$ may be used. While an ArF gas is used for the excimer laser, it is possible to use KrF gas in the case of depositing an Si layer with $Si_3H_6$.

The reaction gas inlet port 108 is preferably provided in proximity to the deposition substrate 107 in order to prevent the generation of reaction product in unwanted areas of the reaction chamber 101. Next, the purge gas, $N_2$ for example, in amount of 10 litres/minute is supplied from the purging gas inlet port 105 in order to prevent the reaction gas from entering the laser inlet port 102 and thereby causing the synthetic quartz window 104 to become cloudy. Thereafter, the deposition substrate 107 disposed on the heater 111 is heated up to a temperature of about 300°C. Next, the laser beam 100 is guided to the reaction chamber through the synthetic quartz window 104. The laser beam is a pulsed ArF excimer laser, for example, with an output of 12 W, a frequency of 50 Hz, pulse energy of 240 mJ and a wavelength of 198 nm. The beam has a width of about 1 cm and a height of about 2 cm when emitted from the laser source 114. As explained above, when the inside of the reaction chamber 101 is exposed to the laser beam 100, the reaction gas generates a radical beam of purple appearance through decomposition and reaction of only the gas exposed to the laser beam. The $SiO_2$ thus generated is gradually deposited on the deposition substrate 107.

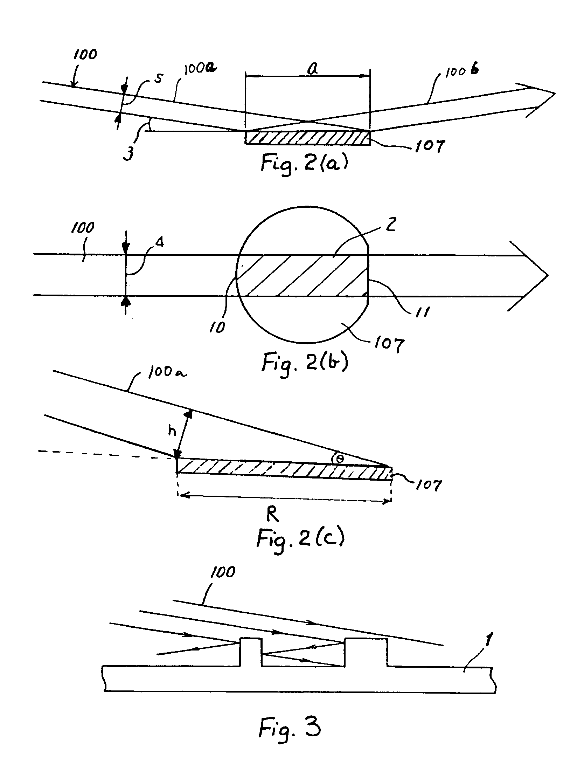

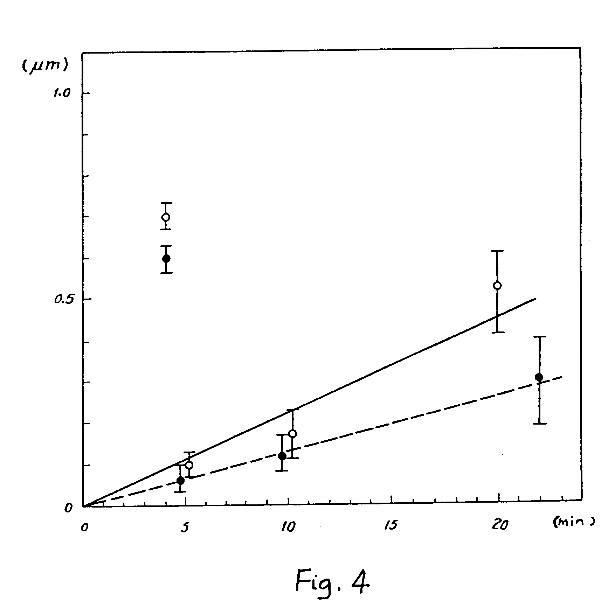

Figs. 2(a) and 2(b) are schematic diagrams illustrating the laser beam which is irradiated on the deposition substrate according to a preferred embodiment of the present invention. Fig. 2(a) is a sectional view and Fig. 2(b) is a top plan view. Fig. 3 is a schematic sectional view for explaining the improvement in step coverage in a preferred embodiment of the present invention. Fig. 4 is a graph showing the effect on the deposition rate obtained with an apparatus according to the present invention in comparison with that obtained with a known apparatus.

In these Figures, a deposition substrate 107 has a region 2 on which a deposition film is formed. The region 2 has a length defined between the opposite ends 10 and 11 of the deposition substrate 107. The width of the region 2 is defined by the width 4 of the laser beam 100.

As indicated in Figs. 2(a) and 2(b), a deposition substrate 107, for example, a flat plate having a diameter of about 10 cm, is placed in an appropriate position in an atmosphere including the reaction gas ($Si_2H_6$ and $N_2O$). Thereafter, the deposition substrate 107 is irradiated With the laser beam 100, e.g. the ArF excimer laser beam, such that the laser beam is projected on the surface of deposition substrate 107. In this case, the angle of incidence of the laser beam 100 in its direction of propagation which contacts tie deposition substrate at least completely includes the length of tie region 2 defined between the opposite ends 10 arid 11 of the deposition substrate 107.

If the laser beam 100 to be irradiated has a width 4 of 4 cm and a height 5 of 1 cm, the angle of incidence 3, which is also the angle of irradiation, is about 6°. Moreover, in case the height 5 of the beam 100 is 1 cm and width 4 is 4 cm, the irradiation angle of about 4° to 10° is necessary to irradiate completely the region 2 having a size of from about 1.6 to 15.2 cm (3 to 6 inches).

In the method of forming a deposition film using the laser CVD technique described heretofore, implemented in the apparatus embodying the invention, a deposition film is formed in a wider area on the substrate surface, even without using a lens system for expanding the beam diameter of the laser beam. This is accomplished by setting the angle of incidence to such a low angle that the laser beam strikes the entire length of the deposition substrate in the irradiation direction of the laser beam. Moreover, since a lens system is not employed, energy loss of the laser beam is reduced, and thus, energy efficiency of the laser beam is enhanced.

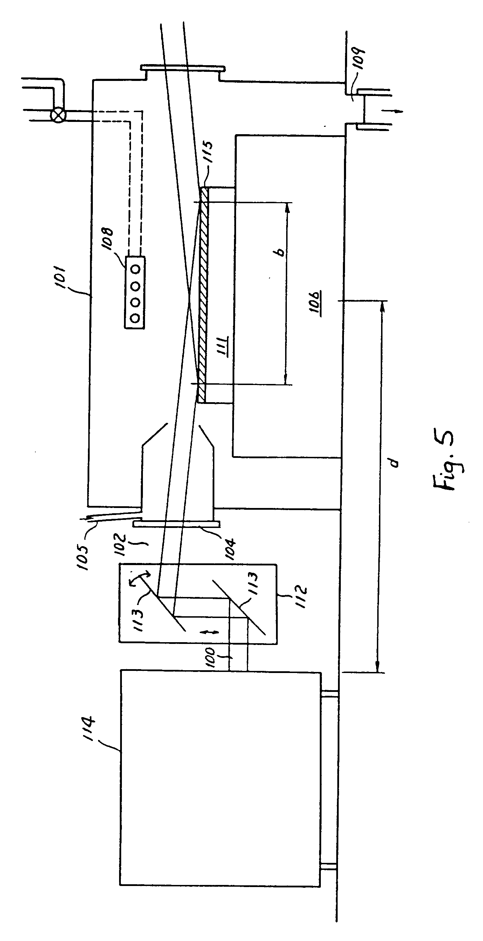

Fig. 5 is a schematic diagram illustrating a method for setting the irradiation angle or angle of incidence of the laser beam 100 for a deposition substrate and laser beam of a particular size, which method can be implemented in the apparatus embodying the present invention.

This figure illustrates a fluorescent plate 115, a beam angle adjusting mechanism 112, arid a mirror body 113. The distance "d" is the distance between the ArF excimer laser source 114 and the fluorescent plate 115.

First, prior to forming the thin film on the deposition substrate with the laser CVD technique, a substance which generates fluorescence when irradiated by the laser beam 100, such as a fluorescent plate 115, is set on the heater 111 on which the deposition substrate is to be set within the reaction chamber 101. Next, when the ArF excimer laser source 114 is turned ON, the laser beam 100 irradiates the fluorescent plate 115 after passing from the ArF excimer laser source 114, through the beam angle adjusting mechanism 112 and synthetic quartz window 104. Next, the beam angle is adjusted with a beam angle adjusting mechanism 112 so that the irradiation range "b" for the fluorescent plate 115 of the laser beam becomes at least as long as a diameter (lengthwise) of the deposition substrate to be deposited later. The range b is the distance that the laser beam travels over the fluorescent plate 115, and eventually, the deposition substrate 107. The beam angle adjusting mechanism 112 has a mirror body 113 and the irradiation angle of the laser beam relative to the deposition substrate can be set by adjusting the angle and/or height of the laser beam 100 emanating from the mirror body 113. Adjustment of the mirror body may be done with a driving apparatus (not illustrated) or manually.

Adjustment of the beam diameter will now be explained. As described previously, the laser beam generated from the ArF excimer laser source 114 in one embodiment has a width of 2 cm and a height of 1 cm. Since this laser beam has an intrinsic beam divergence, the beam diameter becomes larger until it reaches the fluorescent plate 115. Therefore, the beam diameter can be adjusted to a certain degree by adjusting the distance "d" between the ArF excimer laser source 114 and the fluorescent plate 115.

After setting the irradiation angle of the laser beam according to the steps described above, the fluorescent plate 115 is taken out from the reaction chamber 101 and a deposition substrate is then set on the heater 111 in place of the fluorescent plate 115. The deposition substrate can now easily be irradiated with the laser beam at the desired angle.

However, as shown in Fig. 2(b), a thin film can be formed on only a part of the deposition substrate 107 so long as the positions of the deposition substrate and the laser beam are fixed. Accordingly, the stage 106 supporting the deposition substrate 107 is moved in a direction perpendicular to the direction of beam irradiation at a rate, for example, of 2 cm/second, or the laser beam 100 is scanned to the right and left at a rate, e.g. of 2 cm/second in order to form a thin film on the entire part of the deposition substrate 1. However, when the laser beam is scanned, the driving mechanism of the beam angle setting apparatus 112 is complicated and the synthetic quartz window 104 of the reaction chamber 101 must also be formed larger in size. Therefore, it is preferable to employ the method of moving the stage 106 instead of moving the beam.

Fig. 4 is a graph indicating the relationship between the irradiation time and deposition film thickness when a laser beam with an output of 12 W, a frequency of 50 Hz and a pulse energy of 240 mJ is used. In this Figure, a solid line indicates the relationship between the irradiation time and the deposition film thickness obtained by using a small angle of irradiation for the laser beam according to the present invention, while a broken line indicates the relationship between tie irradiation time and the deposition film thickness obtained by using a parallel irradiation laser beam. As will be apparent from the Figure, the method implemented in the apparatus embodying the present invention assures a faster deposition rate due to the generation of a reaction of the reaction gas in a region closer to the deposition substrate. The known apparatus, in contrast, produce reaction product in a region spaced from the deposition substrate and deposits the same at regions other than the deposition substrate.

Moreover, a shown in Fig. 3, when the surface of the deposition substrate has projecting and recessed portions (depth of about 1 $\mu$m) and is irradiated at a low angle With the laser beam, the laser beam is reflected into and irradiates the projecting and recessed portions of surface and thereby improves step coverage in comparison with the known methods corresponding to Fig. 6(a). Accordingly, the reaction product produced in the vicinity of the deposition substrate is also deposited on the deposition substrate. Moreover, the recessed part of substrate surface is also irradiated with the laser beam and reaction product generated by irradiation is further deposited on the substrate.

The irradiation angle of the laser beam as described throughout the present disclosure refers to the angle at which the laser beam 100 is emitted into the reaction chamber. The irradiation angle is equal to the angle of incidence, which refers to the angle at which the laser beam strikes either the deposition substrate 107 or the fluorescent plate 115. Another aspect of the present invention is to determine the maximum acceptable angle of incidence ($\theta_0$) and to adjust the angle of incidence according to that determination. As previously stated, the irradiation angle is preferably adjusted in such a way that the laser beam is at a low angle so that the substrate 107 is all included within a range of the laser beam. Thus, as shown in Fig. 2(a), the range of the laser beam coincides with the length "a", which is the length of the region of the deposition substrate 107. Thus, the angle 3 is acceptable.

In Fig. 5, the range of the laser beam 100 is indicated by the distance b, and to the extent that the range b is less than the corresponding length of the irradiation region of the fluorescent plate 115, the irradiation angle would have to be adjusted downwardly to increase the range of the laser beam.

Fig. 2(c) illustrates the incidence portion 100a of the laser beam as having a height h and an angle of incidence $\theta$. Thus, the lower perimeter of the incidence beam 100a coincides with one end of the deposition substrate 107, while the upper perimeter of the incidence beam 100a coincides with the opposite end of the deposition substrate 107. The angle $\theta$ whereupon the lower perimeter coincides with the one end and the upper perimeter coincides with the opposite end of the deposition substrate 107 can be determined as follows:

$$\theta_0 \leq \sin^{-1} W/R,$$

where W is the height of the laser beam and R is a diameter of the deposition substrate 107 corresponding to the length between opposite ends 10 and 11 (see Fig. 2(b)).

Thus, in order to include the length of the deposition substrate within a range of the laser beam, the irradiation angle, or the angle of incidence $\theta$, must be smaller than $\theta_0$.

As art example of a relatively low, shallow or small angle of inclination of the laser beam to the surface of the substrate, when W = 1 centimetre and R is equal to 1.62 cm (3 inches), $\theta$ is $\leq 7.54°$. Similarly, when W = 1 centimetre and R = 15.25 cm (6 inches), $\theta$ is $\leq 3.76°$. When W = 2 centimetre and R = 7.62 cm, $\theta \leq 15.22°$. Since W $\leq 2$ centimetres and R is $\geq 7.6$ cm (3 inches) for most practical uses, the range of $\theta$ normally would not exceed 20°, although a preferred range, as previously mentioned, would be in the range of 4° to 10°.

While it is possible for $\theta$ to equal 45° when W is equal to 1 centimetre and R is equal to 1.44 centimetres (thus calling for an angle corresponding to the angle shown in Fig. 6(c)) this could not be practically implemented since the diameter of the deposition substrate 107 is for most practical uses more than about 7.6 cm (3 inches).

As described earlier, the present invention is capable of irradiating a wider range of deposition substrate with the laser beam without expanding the laser beam with a lens system. Moreover, the present invention ensures that setting of the laser beam irradiation angle relative to the deposition substrate is done very easily.

**Claims**

1. A laser CVD apparatus for forming a deposition film on a deposition substrate, comprising:

    a laser source (114), and

    a reaction chamber (101) having a laser inlet port (102) through which a laser beam from the laser source (114) can enter the reaction chamber (101) for irradiating a reaction gas in the reaction chamber (101) with the laser beam, thereby to produce a reaction product by decomposition and reaction of said reaction gas, and deposit said reaction product on a surface of the deposition substrate (107) arranged in the reaction chamber,

    characterised in that

    the apparatus further comprises a beam angle setting mechanism (112), between the laser source (114) and the laser inlet port (102), operable to project the laser beam onto the surface of the deposition substrate arranged in the reaction chamber and to set the angle of incidence of the laser beam, in its direction of propagation, for contacting and irradiating the surface of the deposition substrate (107), at a relatively low angle selected such that the deposition substrate is all included within the beam range of the laser beam in its direction of propagation,

    and in that the apparatus lacks any lens system between the laser source (114) and the surface of the deposition substrate (107) arranged in the reaction chamber (101).

2. Apparatus according to claim 1, wherein the laser source (114) is an ArF excimer laser.

3. Apparatus according to claim 1 or 2, wherein the laser beam has a width of about 4 cm and a height of about 1 cm in the vicinity of the deposition substrate, the diameter of the deposition substrate is between about 7.6 and 15.25 cm (3 and 6 inches), and the beam angle setting mechanism (112) is operable to set the irradiation angle of the laser beam to the deposition substrate between 4° and 10°.

4. Apparatus according to any preceding claim, operable to carry out deposition with a reaction gas comprising $N_2O$ and $Si_2H_6$, the deposition film deposited on said deposition substrate being $SiO_2$.

5. Apparatus according to any preceding claim, further comprising a moveable stage (106) supporting the deposition substrate (107) perpendicularly relative to the direction of propagation of the laser beam, to provide for forming the deposition film on the whole of the surface of said deposition substrate.

6. Apparatus according to any preceding claim, further comprising a fluorescent plate (115) disposable in the reaction chamber (101) to allow irradiation of the laser beam from the laser beam source (114) into the reaction chamber and onto a range of the fluorescent plate, for the purpose of setting the angle of incidence for a laser beam emitted from a laser beam source (114) onto the deposition substrate (107) prior to arrangement of the deposition substrate in the reaction chamber (101), whereby the angle of incidence for the laser beam can be set so that the range of the laser beam at least coincides with the length of the deposition substrate to be irradiated, the fluorescent plate (115) being removed from the reaction chamber and the deposition substrate (107) disposed where the fluorescent plate was positioned, before deposition is commenced.

7. Apparatus according to any preceding claim, wherein the beam angle setting mechanism (112) comprises a mirror assembly (113) operable to vary the height and angle of the laser beam relative to the deposition substrate (107).

8. A method of operating apparatus according to any preceding claim, wherein the angle of irradiation of the laser beam is set to $\theta$, such that $\theta \leq \sin^{-1} W/R$ where W is the height dimension of the laser beam, and R is the diameter of the deposition substrate (107) in the direction of propagation of the laser beam.

**Patentansprüche**

1. CVD-Laservorrichtung zur Erzeugung eines Abscheidungsfilms auf einem Ablagerungssubstrat, beinhaltend:-
eine Laserquelle (114); eine Reaktionskammer (101) mit einem Lasereinlaß (102), durch den der Laserstrahl der Laserquelle (114) in die Reaktionskammer (101) zum Bestrahlen eines Reaktionsgases in der Reaktionskammer (101) gelangen kann, so daß ein Reaktionsprodukt durch Zersetzen und Umsetzen des Reaktionsgases erzeugt wird, und Abscheiden des Reaktionsprodukts auf einer Oberfläche des in der Reaktionskammer angeordneten Ablagerungssubstrats (107);
**dadurch gekennzeichnet**,
daß die Vorrichtung eine Strahlwinkeleinstellung (112) zwischen der Laserquelle (114) und dem Lasereinlaß (102) aufweist, womit der Laserstrahl auf die Oberfläche des in der Reaktionskammer angeordneten Ablagerungssubstrats gerichtet und sein Einfallswinkel eingestellt werden kann, und seine Ausbreitungsrichtung - für ein Kontaktieren und Bestrahlen der Oberfläche des Ablagerungssubstrats (107) - wird mit einem vergleichsweise kleinen Winkel so gewählt, daß das Ablagerungssubstrat sich insgesamt innerhalb der Strahlweite des Laserstrahls in Ausbreitungsrichtung befindet, und daß die Vorrichtung kein Linsensystem zwischen der Laserquelle (114) und der Oberfläche des in der Reaktionskammer (101) angeordneten Ablagerungssubstrats (107) aufweist.

2. Vorrichtung nach Anspruch 1, wobei die Laserquelle (114) ein ArF-Excimerlaser ist.

3. Vorrichtung nach Anspruch 1 oder 2, wobei der Laserstrahl in der Nähe des Ablagerungssubstrats ca. 4 cm breit ist und ca. 1 cm hoch ist, der Durchmesser des Ablagerungssubstrats zwischen ca. 7,6 und 15,25 cm (3 bis 6 Inch) beträgt und die Strahlwinkeleinstellung (112) so verwendbar ist, daß der Bestrahlungswinkel des Laserstrahls auf das Ablagerungssubstrat zwischen 4° und 10° beträgt.

4. Vorrichtung nach irgendeinem vorhergehenden Anspruch, betreibbar für ein Abscheiden aus einem Reaktionsgas, das $N_2O$ und $Si_2H_6$ aufweist, und der auf dem Ablagerungssubstrat abgeschiedene Abscheidungsfilm $SiO_2$ ist.

**5.** Vorrichtung nach irgendeinem vorhergehenden Anspruch, beinhaltend weiter eine Bühne (106), die das Ablagerungssubstrat (107) trägt, und die senkrecht beweglich ist zur Ausbreitungsrichtung des Laserstrahls, so daß der Abscheidungsfilm auf der gesamten Fläche des Ablagerungssubstrats erzeugbar ist.

**6.** Vorrichtung nach irgendeinem vorhergehenden Anspruch, beinhaltend weiter eine fluoreszierende Platte (115), die in der Reaktionskammer (101) so anbringbar ist, daß der Laserstrahl der Laserstrahlquelle (114) in der Reaktionskammer auf einen Bereich der fluoreszierenden Platte fällt, damit der Einfallswinkel des Laserstrahls der Laserstrahlquelle (114) auf das Ablagerungssubstrat (107) - vor einem Anbringen des Ablagerungssubstrats in der Reaktionskammer (101) - einstellbar ist, so daß der Einfallswinkel des Laserstrahls so einstellbar ist, daß die Reichweite des Laserstrahls zumindest zur Länge des zu bestrahlenden Ablagerungssubstrats paßt; die fluoreszierende Platte (115) wird, bevor mit dem Abscheiden begonnen wird, aus der Reaktionskammer genommen und das Ablagerungssubstrat (107) an die Stelle gebracht, wo die fluoreszierende Platte stand.

**7.** Vorrichtung nach irgendeinem vorhergehenden Anspruch, wobei die Strahlwinkeleinstellung (112) beinhaltet: eine Spiegelanordnung (113), mit der die Höhe und der Winkel des Laserstrahls zum Ablagerungssubstrat (107) einstellbar ist.

**8.** Verfahren zum Betrieb einer Vorrichtung nach irgendeinem vorhergehenden Anspruch, wobei der Bestrahlungswinkel $\theta$ des Laserstrahls so eingestellt wird, daß $\theta \leq \sin^{-1} W/R$ ist, worin W die Höhenabmessung des Laserstrahls ist und R der Durchmesser des Ablagerungssubstrats (107) in Ausbreitungsrichtung des Laserstrahls.

**Revendications**

**1.** Appareil de dépôt chimique en phase vapeur en présence d'un laser destiné à former un film déposé sur un substrat, comprenant :
une source laser (114), et
une chambre de réaction (101) ayant un orifice (102) d'entrée de laser par lequel un faisceau laser de la source laser (114) peut pénétrer dans la chambre de réaction (101) pour l'irradiation d'un gaz réactif dans la chambre de réaction (101) avec le faisceau laser, si bien qu'un produit de la réaction est obtenu par décomposition et réaction du gaz réactif, et le produit de la réaction se dépose sur une surface du substrat (107) placé dans la chambre de réaction,
caractérisé en ce que :
l'appareil comporte en outre un mécanisme (112) de réglage de l'angle du faisceau, placé entre la source laser (114) et l'orifice (102) d'entrée de laser et destiné à projeter le faisceau laser à la surface du substrat placé dans la chambre de réaction et à régler l'angle d'incidence du faisceau laser, dans sa direction de propagation, afin qu'il soit au contact de la surface du substrat (107) et irradie cette surface avec un angle relativement faible choisi de manière que le substrat soit entièrement incorporé dans la plage du faisceau laser dans sa direction de propagation, et
en ce que l'appareil ne comporte aucun système à lentille placé entre la source laser (114) et la surface du substrat (107) placé dans la chambre de réaction (101).

**2.** Appareil selon la revendication 1, dans lequel la source (114) est un laser à excimère à ArF.

**3.** Appareil selon la revendication 1 ou 2, dans lequel le faisceau laser a une largeur d'environ 4 cm et une hauteur d'environ 1 cm au voisinage du substrat, le diamètre du substrat est compris entre environ 7,6 et 15,25 cm (3 et 6 pouces), et le mécanisme (112) de réglage de l'angle du faisceau est destiné à régler l'angle d'irradiation du substrat par le faisceau laser à une valeur comprise entre 4 et 10°.

**4.** Appareil selon l'une quelconque des revendications précédentes, destiné à réaliser le dépôt avec un gaz réactif contenant $N_2O$ et $Si_2H_6$, le film déposé sur le substrat étant formé de $SiO_2$.

**5.** Appareil selon l'une quelconque des revendications précédentes, comprenant en outre une platine mobile (106) qui supporte le substrat (107) perpendiculairement par rapport à la direction de propagation du faisceau laser, afin que le film soit déposé sur toute la surface du substrat.

**6.** Appareil selon l'une quelconque des revendications précédentes, comprenant en outre une plaque fluorescente (115) destinée à être placée dans la chambre de réaction (101) afin qu'elle permette l'irradiation de la chambre de réaction et de toute une plage de la plaque fluorescente par le faisceau laser provenant de la source (114), afin que l'angle d'incidence d'un faisceau laser émis par la source (114) sur le substrat (107) soit réglé avant la disposition du substrat dans la chambre de réaction (101), si bien que l'angle d'incidence du faisceau peut être réglé afin que la plage du faisceau laser coïncide au moins avec la longueur du substrat à irradier, la plaque fluorescente (115) étant retirée de la chambre de réaction et le substrat (107) étant placé à l'emplacement qu'occupait la plaque fluorescente, avant le début du dépôt.

7. Appareil selon l'une quelconque des revendications précédentes, dans lequel le mécanisme (112) de réglage d'angle du faisceau comprend un ensemble à miroir (113) destiné à faire varier la hauteur et l'angle du faisceau laser par rapport au substrat (107).

8. Procédé de commande d'un appareil selon l'une quelconque des revendications précédentes, dans lequel l'angle d'irradiation du faisceau laser est réglé à une valeur $\theta$ tel que $\theta \le \sin^{-1} W/R$, W étant la dimension en hauteur du faisceau laser et R étant le diamètre du substrat (107) dans la direction de propagation du faisceau laser.

Fig. 1

Fig. 2(a)

Fig. 2(b)

Fig. 2(c)

Fig. 3

Fig. 4

Fig. 5

13

Fig. 6 (a)

Fig. 6 (b)

Fig. 6 (c)

Fig. 7.